# EUROPEAN PATENT APPLICATION

(11) **EP 0 980 025 A1**
(43) Date of publication of application: **16.02.2000**
(21) Application number: 99402042.8
(22) Date of filing: 11.08.1999
(51) Int. Cl.: G03F 7/00, G03F 7/027

(54) **Hologram recording material composition, hologram recording medium, and process for producing the same.**

(30) Priority: 12.08.1998 JP 22781898
(71) Applicant: AGENCY OF INDUSTRIAL SCIENCE AND TECHNOLOGY, Tokyo 100 (JP); Ichihashi, Taichi, Ikeda-shi, Osaka (JP); Tanigawa, Hideo, Ikeda-shi, Osaka (JP); DAISO CO., LTD., Osaka-shi, Osaka 550-0002 (JP)
(72) Inventor: Ichihashi, Taichi, c/o Osaka National Rch. Inst., Ikeda-shi, Osaka (JP); Tanigawa, Hideo, c/o Osaka National Rch. Inst., Ikeda-shi, Osaka (JP); Kamada, Yutaka, Amagasaki-shi, Hyogo (JP); Nakamura, Shoukichi, Amagasaki-shi, Hyogo (JP); Matsuo, Takashi, Amagasaki-shi, Hyogo (JP)
(74) Representative: Peaucelle, Chantal

(57) **Abstract**

A hologram recording material composition is disclosed, comprising (A) an allyl-based prepolymer having at least one allyl group in a molecule thereof, (B) a (meth)acrylate-based compound having at least one polymerizable unsaturated group in a molecule thereof, and (c) a photo-polymerization initiator, wherein a difference between a refractive index of said allyl-based prepolymer (A) and a refractive index of a polymer of said (met)acrylate compound (B) is 0.005 or more.

## Description

### FIELD OF THE INVENTION

The present invention relates to a novel hologram recording material composition, and particularly a hologram recording material composition that can be easily formed into a film on production of a hologram recording medium, and it also relates to a hologram recording material obtained therefrom and a process for producing the same.

### BACKGROUND OF THE INVENTION

A hologram is a record of an interference pattern of coherent laser light on a photosensitive material, and is used in various field, such as an optical device, a three-dimensional display, interferometry and processing of an image and information, owing to the multi-functionality thereof.

As a representative example of the conventional hologram recording material composition, a gelatin dichromate photosensitive material and a breached silver salt photosensitive material (described, for example, in Display Holography Handbook, p. 66 to 67 (Gyoin Shokan, 1985) and Optical Engineering Handbook, p. 351 to 353 (Asakura Shoten, 1986)).

However, although gelatin dichromate has a high diffraction efficiency, and a silver salt photosensitive material has a high sensitivity, these materials require a complicated process on production of a hologram, and particularly they have a problem in that they require a wet development process.

As a photosensitive material to eliminate the problem, a hologram recording material composition containing a photo-polymerizable monomer is proposed. In this material, a photo-polymerizable monomer is polymerized in a portion having a large light amount in the interference pattern to cause a refractive index modulation in that portion, and thus a hologram is recorded. Examples thereof include a photo-polymerization type recording material mainly comprising cyclohexyl methacrylate and N-vinylcarbazole as photopolymerizable monomers; and a photo-polymerization initiator, and a photo-polymerization type recording material mainly comprising butyl methacrylate and ethylene glycol dimethacrylate as photopolymerizable monomers, and 1-phenylnaphthalene as an inert component not participating in the polymerization; and a photo-polymerization initiator (as described in Appl. Opt., vol. 15, p. 534 (1976)). However, because these materials are in a liquid state, the composition flows between two surface materials on recording a hologram to prevent recording in good conditions. Furthermore, a unreacted monomer remains after recording the hologram in a portion of a small light amount, and therefore the record is necessarily stabilized by conducting an exposure treatment on the whole surface.

JP-A-3-36582 and JP-A-3-249685 disclose a hologram recording material composition mainly comprising an allyl monomer and an acryl monomer that have different polymerization reactivities and different refractive indices of resulting polymers. Upon using the composition, a heat treatment is conducted after filling the composition between two surface materials to suppress the flowability of the composition, and thus the problems are to be solved.

However, the hologram recording material composition requires a heat treatment to be fixed between the two surface materials, and has a problem in that the process of film formation becomes complicated.

### SUMMARY OF THE INVENTION

An object of the invention is to provide a hologram recording material composition that can eliminate the problems associated with the conventional products, i.e., the complicated process of film formation, with exhibiting the excellent performance, such as transparency, diffraction efficiency and resolution, equivalent to the conventional products.

As a result of earnest investigations to attain the object described above by the inventors, a novel hologram recording material composition has been developed to complete the invention.

The invention relates to a hologram recording material composition comprising (A) an allyl-based prepolymer having at least one allyl group in a molecule thereof, (B) a (meth)acrylate-based compound having at least one polymerizable unsaturated group in a molecule thereof, and (C) a photo-polymerization initiator, wherein a difference between a refractive index of the allyl-based prepolymer (A) and a refractive index of a polymer of the (meth)acrylate compound (B) is 0.005 or more.

### DETAILED DESCRIPTION OF THE INVENTION

The allyl-based prepolymer (A) used in the invention is a prepolymer having at least one allyl group in its molecule, and representative examples thereof include a diallyl phthalate-based prepolymer. The allyl-based prepolymer (A) can be a homopolymer of an allyl-based monomer or a copolymer of the allyl-based monomer and another copolymerizable monomer. Examples of the copolymerizable monomer include aromatic vinyl compounds, such as styrene, α-methylstyrene and divinylbenzene. In general, the copolymer mainly comprises a diallylphthalate constitutional unit. The diallylphthalate-based monomer as a starting material of the diallyl phthalate-based prepolymer is a compound selected from the group consisting of a diallylorthophthalate monomer, a diallylisophthalate monomer and diallylterephthalate monomer, and a combination of two or more of them. In order to obtain the diallyl phthalate-based prepolymer by homopolymerization of the diallyl phthalate-based monomer, the known polymerization reaction described, for example, in JP-B-35-16035 can be conducted. In order to obtain the diallylphthalate-based prepolymer by copolymerization of the diallylphthalate-based monomer, as the main component, with another monomer copolymerizable with the diallyl phthalate-based monomer, the known polymerization reaction described, for example, in Kogyo Kagaku Zasshi, vol. 70(3), p. 360 to 364 (1967) can be conducted. As the allyl-based prepolymer (A) used in the invention, a homopolymer, such as a diallylorthophthalate prepolymer, e.g., "Daiso DAP" produced by Daiso Co., Ltd., a diallylisophthalate prepolymer, e.g., "ISO DAP" produced by Daiso Co., Ltd., and a diallylterephthalate prepolymer are preferred. The diallylterephthalate prepolymer can be, for example, a modified product thereof, e.g., "Daplen" produced by Daiso Co., Ltd.

Furthermore, the allyl-based prepolymer (A) can be an organic-inorganic complex transparent uniform material, which is a metallic oxide polymer obtained through dehydration condensation by a sol-gel method, for example, of a metallic alkoxide having a metallic atom, a group having an aromatic ring, and a hydrolyzable group as shown by the general formula below in the presence of a diallyl phthalate-based monomer and/or a diallyl phthalate-based polymer (see WO 99/14274).

Tne metallic alkoxide is a substance represented by the general formula:

XₘM(Ar)ₙR² ₚ

wherein X represents an alkoxy group represented by the general formula R¹O (wherein R¹ represents a monovalent organic group); M represents a metallic atom selected from the group consisting of silicon, titanium, zirconium germanium and aluminum; Ar represents a group having an aromatic ring; R² represents a monovalent organic group; m and n are a number of 1 or more; and p is a number of 0 or more, provided that m + n + p is the valence number of the metallic atom represented by M.

Specific examples of a metallic alkoxide having a tetravalent metallic atom (e.g., Si, Ti, Zr and Ge) include the following; (CH₃O)₃MPh, (C₂H₅O)₃M(CH₂Ph), (C₂H₃O)₃M(C₂H₄OPh), (C₃H₈NO)₃MPh, (C₄H₉O)₃M(C₃H₄Ph), (CH₄NO)₂MPh₂, (C₂H₅O)₂M(CH₃MPh)₂, (C₃H₅O)₂M(C₄H₈Ph)₂, (C₄H₁₀NO)₂M(C₂H₂O₂Ph)₂, (CH₃O)₂M(C₄H₉NPh)(C₄H₉), (C₂H₅O)₂M(C₄H₆O₂Ph)(C₃H₅), (C₂H₃O)₂M(C₂H₄Ph)(C₂H₅O), (C₃H₈NO)₂M(CH₂Ph)(CH₄N), (C₄H₉O)₂MPh(CH₃), (CH₄NO)₂MPh(C₂H₅), (C₂H₅O)₂M(CH₂Ph)(C₃H₇O), (C₃H₅O)₂M(C₂H₂Ph)(C₅H₉O₂), (C₄H₁₀NO)₂MPh(C₄H₁₀N), (CH₃O)₂M(CH₂OPh)(C₃H₇), (C₂H₅O)₃M(C₅H₈O₂Ph)(C₄H₉), (C₂H₃O)₂MPh(C₃H₈N), (C₃H₈NO)₂M(C₂H₄Ph)(C₂H₅), (C₄H₉O)₂MPh(C₂H₃O₂), (CH₄NO)₂MPh(C₃H₇), (C₂H₅O)₂M(CH₃NPh)(C₃H₅O₂), (C₃H₅O)₂M(C₄H₈Ph)(C₂H₃) and (C₄H₁₀NO)₂M(C₂H₂O₂Ph)(CH₃).

Preferred examples of metallic alkoxide are phenylalkoxysilane such as (CH₃O)₃MPh, (C₂H₅O)₃MPh, (C₃H₇O)₃MPh, (C₄H₃O)₃MPh, (CH₃O)₂MPh₂, (C₂H₅O)₂MPh₂, (C₃H₇O)₂MPh₂ or (C₄H₉O)₂MPh₂ and phenyltrimethoxysilane is the most preferable among them.

Preferred examples of Aluminum alkoxide include the following. (CH₃O)₂AlPh, (C₂H₅O)₂AlPh, (C₃H₇O)₂AlPh, (C₄H₉O)₂AlPh, (CH₃O)AlPh₂, (C₂H₅O)AlPh₂, (C₃H₇O)AlPh₂, (C₄H₉O)AlPh₂.

The allyl-based prepolymer (A) can have a thioether group and/or a halogen atom connected to the main chain thereof. The introduction of a thiosther group and/or a halogen atom is conducted by a method where a thiol compound and/or a halogen is added to a polymerization system of an allyl-based monomer, or a method where a thiol compound and/or a halogen are subjected to an addition reaction with the allyl-based prepolymer (A). Examples of the thiol compound used for the introduction of a thioether group include a thiophenol-based compound, such as thiophenol, 2-chlorothiophenol, 4-chlorothiophenol, 4-tert-butylthiophenol and 4-mercaptophenol; dithiol-based compound such as 4,4'-thiodibenzenethiol; aliphatic thiol compound such as n-butylmercaptan and n-laurylmercaptan. Examples of the halogen used for the introduction of an halogen atom include bromine and chlorine.

Examples of each of the homopolymer or copolymer of an allyl-based monomer, the organic-inorganic complex transparent material, and the allyl-based prepolymer containing a thioether group (or a halogen atom) can be used singly or in combination of two or more of them. Furthermore, the homopolymer or copolymer of an allyl-based monomer can be used in combination with the organic-inorganic complex transparent material and/or the allyl-based prepolymer containing a thioether group (or a halogen atom).

It is particularly preferred that the diallylphthalate-based prepolymer is a prepolymer that can be subjected to post-polymerization having a softening temperature of from 50 to 110°C, an iodine value measured by the Wijs method of from 50 to 95, a viscosity as a methyl ethyl ketone 50% solution (30°C) of from 50 to 300 cp, and an average molecular weight of polystyrene conversion measure by the GPC (gel permeation chromatography) method of from 10,000 to 100,000, and preferably from 30,000 to 60,000.

The (meth)acrylate-based compound (B) used in the invention is a compound having at least one polymerizable unsaturated group, such as a (meth)acryl group, in the molecule, and is a compound obtained by esterification of (meth)acrylic acid with a monovalent or polyvalent alcohol, and an oligomer, such as a dimer and a trimer, thereof. The (meth)acrylate-based compound (B) can be fluorene (meth)acrylate. In general, a polymer of the (meth)acrylate-based compound (B) has a refractive index smaller than that of the allyl-based prepolymer (A), provided that a polymer of fluorene (meth)acrylate has a refractive index larger than the refractive index of the allyl-based prepolymer (A). The (meth)acrylate-based compound (B) has at least one, preferably from 1 to 6, polymerizable unsaturated group in the molecule. The (meth)acrylate-based compound (B) has a molecular weight of preferably 2,000 or less, and more preferably 1,500 or lees. The (meth)acrylate-based compound (B) is selected depending on the extent of the refractive index modulation and the usage of the resulting hologram.

(Meth)acrylate-based compound (B) are exemplified as follows.

Examples of mono(meth)acrylate include the following. Methyl methacrylate, ethyl methacrylate, n-butyl methacrylate, isobutyl methacrylate, 2-ethylhexyl methacrylate, isodecyl methacrylate, n-lauryl methacrylate, n-stearyl methacrylate, methoxydiethylene glycol methacrylate, cyclohexyl methacrylate, tetrahydrofurfuryl methacrylate, benzyl methacrylate, phenoxyethyl methacrylate, isobornyl methacrylate, 2-hydroxyethyl methacrylate, 2-hydroxypropyl methacrylate, 2-hydroxyethyl acrylate, 2-hydroxypropyl acrylate, 2-hydroxybutyl methacrylate, dimethylaminoethyl methacrylate, diethylaminoethyl methacrylate, glycidyl methacrylate, tert-butyl methacrylate, isostearyl methacrylate, n-butoxyethyl methacrylate, isoamyl acrylate, lauryl acrylate, stearyl acrylate, butoxyethyl acrylate, ethoxyethylene glycol acrylate, methoxytriethylene glycol acrylate, phenoxyethyl acrylate, tetrahydrofurfuryl acrylate, isobornyl acrylate, 2-hydroxyethyl acrylate, 2-hydroxypropyl acrylate, 2-hydroxy-3-phenoxypropyl acrylate, 2-acryloyloxyethylsuccinic acid, 2-acryloyloxyethylphthalic acid, isooctyl acrylate, isomyristyl acrylate, isostearyl acrylate.

Examples of di(meth)acrylate include the following. Ethylene glycol dimethacrylate, diethylene glycol dimethacrylate, triethylene glycol dimethacrylate, tetraethylene glycol dimethacrylate, nonaethylene glycol diacrylate, 1,4-butanediol dimethacrylate, 1,6-hexanediol dimethacrylate, 1,9-nonanediol dimethacrylate, glycerin dimethacrylate, 2-hydroxy-3-acryloyloxypropyl methacrylate, neopentyl glycol dimethacrylate, 1,3-butanediol dimethacrylate, 1,10-decanediol dimethacrylate, ethylene glycol diacrylate, diethylene glycol diacrylate, triethylene glycol diacrylate, tetraethylene glycol diacrylate, 1,4-butanediol diacrylate, 1,6-hexanediol diacrylate, 1,9-nonanediol diacrylate, glycerin diacrylate. 2-hydroxy-3-acryloyloxypropyl acrylate, neopentyl glycol diacrylate, 1,3-butanediol diacrylate, 1,10-decanediol diacrylate.

Examples of tri(meth)acrylate include the following. Trimethylolpropane trimethacrylate, pentaerythritol trimethacrylate, trimethylolpropane triacrylate, pentaerythritol triacrylate.

Examples of tetra(meth)acrylate include the following. Pentaerythritol tetramethacrylate, pentaerythritol tetraacrylate, ditrimethylolpropane tetramethacrylate, ditrimethylolpropane tetraacrylate, tetramethylolmethane tetraacrylate, etc.

Examples of hexa(meth)acrylate include the following. Dipentaerythritol hexamethacrylate, dipentaerythritol hexaacrylate, etc.

Preferred oligomer is a dimer or trimer of a compound obtained by esterification of (meth)acrylic acid with a monovalent or polyvalent alcohol.

Examples of fluorene (meth)acrylate include the following. 9,9-bis(4-(2-(meth)acryloyloxymethoxy)phenyl)fluorene, 9,9-bis(4-(2-(meth)acryloyloxyethoxy)phenyl)fluorene, 9,9-bis(4-(2-(meth)acryloyloxypropoxy)phenyl)fluorene, 9,9-bis(4-(meth)acryloyloxyphenyl)fluorene.

These examples can be used singly or in combination of two or more of them.

Preferred (meth)acrylate-based compounds (B) are di(meth)acrylate-based compounds. Particularly preferred compounds are ethylene glycol dimethacrylate, neopentyl glycol diacrylate, nonaethylene glycol dimethacrylate, polyethylene glycol dimethacrylate (n=14) and 9,9-bis(4-(2-acryloyloxyethoxy)phenyl)fluorene.

In the hologram recording material composition of the invention, the allyl-based prepolymer (A) and the (meth)acrylate compound (B) are selected in such a manner that the difference between the refractive index of the former and the refractive index of the polymer of the later is 0.005 or more, and preferably 0.01 or more. When the difference is less than 0.005, the formation of a hologram is substantially impossible. The difference is about 1.0 at the most.

The hologram recording material composition of the invention has a property close to a solid state and therefore is excellent in handling. In particular, a composition having a weight ratio of the allyl-based prepolymer (A) to the acrylic acid alkyl ester (B). (A)/(B) is from 5/95 to 95/5 has a property further close to a solid state and is further excellent in handling. The weight ratio (A)/(B) is more preferably from 10/90 to 90/10, and most preferably from 20/80 to 80/20.

As the photo-polymerization initiator (C) used in the composition of the invention, those forming a radical by absorbing laser light, such as He-Ne laser (wavelength: 633 nm), Ar laser (wavelength: 515 and 488 nm) and He-Cd laser (wavelength: 442 nm). As the photo-polymerization initiator, for example, a carbonyl compound is preferably used singly or in combination with a photosensitizing dye. A combination of an amine compound and a photosensitizing dye, and a combination of a borate compound and a photosensitizing dye are also effective as the photo-polymerization initiator.

Examples of the carbonyl compound include benzil, benzoin ethyl ether, benzophenone and diethoxyacetophenone.

As the photosensitizing dye, Michler's ketone, Acridine Yellow, merocyanine, methylene blue, camphorquinone, Eosin and decarboxylated rose bengal are preferably used. Any photosensitizing dye can be used as far as it exhibits absorption in the visible region, and in addition to the above, a cyanine derivative, a merocyanine derivative, a phthalocyanine derivative, a xanthene derivative, a thioxanthene derivative, an acridine derivative, a porphyrin derivative, a coumarin derivative, a quinolone derivative, a stilbene derivative, an oxazine derivative and a thiazine dye can be used. Furthermore, photo-sensitizing dyes described in Dye Handbook, edited by S. Ohgawara, et al. (Kodansha, 1986), Chemistry of Functional Dyes, edited by S. Ohgawara, et al. (CMC, 1983), and Special Functional Materials, edited by C. Ikemori, et al. (CMC, 1986) can be used. These can be used singly or in combination of two or more.

Examples of the amine compound include triethanolamine, triisopropanolamine and 2-dimethylamino benzoic acid.

Examples of the borate compound include triphenyl-n-butyl borate.

Specific examples of a combination of the carbonyl compound and the photosensitizing dye include benzil-Michler's ketone, and benzil-Acridine Yellow. As the photosensitizing dye used in combination with the amine compound, decarboxylated rose bengal is preferred. As the photosensitizing dye used in combination with the borate compound, a cyanine-based dye, such as a cyanine, an isocyanine and a pseudocyanine.

The amount of the photo-polymerization initiator (C) added to the composition of the invention is generally about from 0.1 to 15% by weight, and preferably about from 3.3 to 3% by weight, based on 100 parts by weight of the total amount of the allyl-based prepolymer (A) and the (meth)acrylate-based compound (B) in the case where the carbonyl compound is used. In the case where the photo-sensitizing dye is combined with the carbonyl compound, the amine compound or the borate compound, the total amount of these compounds and the photo-polymerization initiator is generally about from 0.1 to 15% by weight, and preferably about from 0.3 to 3% by weight based on 100 parts by weight of the total amount of the allyl-based prepolymer (A) and the (meth)acrylate-based compound (B).

The hologram recording material composition of the invention can further contain a solvent-soluble thermoplastic resin (D) in addition to the allyl-based prepolymer (A), the (met)acrylate-based compound (B) and the photo-polymerization initiator (C). The weight proportion of the thermoplastic resin (D), in terms of a weight ratio to the allyl-based prepolymer (A), (A)/(D) is from 80/20 to 100/0, and preferably from 85/15 to 100/0. As the solvent-soluble thermoplastic resin (D), those having a refractive index of from 1.300 to 1,800 are preferably used, and specific examples thereof include a condensation polymerization product of a diphenol compound and a dicarboxylic acid, a resin having a carbonate group in the molecule, a resin having an -SO₂- group in the molecule, polyvinylidene chloride, and a homopolymer or copolymer obtained by polymerizing at least one monomer having an ethylenic unsaturated double bond. These polymers can be used singly or in combination of two or more thereof.

Examples of the condensation polymerization product of a diphenol compound and a dicarboxylic acid include polyarylate. Examples of the resin having a carbonate group in the molecule include polycarbonate. Examples of the resin having an -SO₂- group in the molecule include polysulfone and polyether sulfone. Examples of the homopolymer or copolymer obtained by polymerizing a monomer having an ethylenic unsaturated double bond include polystyrene, polymethyl methacrylate, an ethylene-vinyl acetate copolymer, polymethylpentene, a cyclic olefin polymer, and a copolymer of a cyclic olefin and ethylene.

In order to obtain a high diffraction efficiency, polyarylate or polysulfone is preferably used.

The hologram recording material composition of the invention can contain additives, such as a viscosity adjusting agent, a compatibility adjusting agent, a heat polymerization inhibitor and a chain transfer agent, and a solvent, if necessary.

Examples of the viscosity adjusting agent and the compatibility adjusting agent include a polymerizable monomer, such as a diallylphthalate-based monomer, styrene, 2,2-bis(4-methacryloyloxyphenyl)propane, 3-phenoxy-2-hydroxypropyl acrylate, divinylbenzene and vinyl biphenylcarboxylate, and an inert compound, such as phthalic ester exemplified by dimethyl phthalate and diethyl phthalate; aliphatic dibasic acid esters exemplified by dimethyl adipate, dibutyl adipate, dimethyl sebacate, diethyl succinate; orthophosphoric acid ester exemplified by trimethyl phosphate, triethyl phosphate, triphenyl phosphate and tricresyl phosphate; acetates exemplified by glyceryl triacetate and 2-ethylhexyl acetate; phosphites exemplified by triphenyl phosphite and dibutylhydrodiene phosphite. It is also possible to use polyethylene glycol or silicone oil having weight-average molecular weight of 10000 or lower.

Inorganic fine particles and organic fine particles can be used as the viscosity adjusting agent. Examples of inorganic fine particles include silica gel fine particles "Daiso gel SP series" produced by Daiso Co., Ltd. Examples of organic fine particles include a diallyl phthalate-based polymer which can be obtained by methods described in JP-A 10-72510 and JP-A LC-310684; and "PB 200 series" produced by Kao Corporation, "Bell Pearl series" produced by Kanebc Ltd.. "Techpolymer series" produced by Sekisui Plastics Co., Ltd., "Micropearl series" produced by Sekisui Fine Chemical Co., Ltd., and "MR series" and "MP series" both produced by Sokan Chemical & Engineering Co., Ltd., which are described in "Most advanced technology of microfine particles", edited by S. Muroi (CMC, 1991).

The amount of the viscosity adjusting agent and the compatibility adjusting agent added is preferably about from 0.5 to 30 parts by weight per 100 parts by weight of the total amount of the allyl-based prepolymer (A) and the (meth)acrylate-based compound (B).

Examples of the heat polymerization inhibitor include hydroquinone, which works to consuming the forming radicals, and examples of the chain transfer agent include an α-methylstyrene dimer.

The solvent is effective to improve the film forming property, as well as the viscosity adjustment and the compatibility adjustment, and for example, acetone, xylene, toluene, methyl ethyl ketone and tetrahydrofuran are preferably used. The amount of the solvent used is about from 0.5 to 1,000 parts by weight per 100 parts by weight of the total amount of the allyl-based prepolymer (A) and the (meth)acrylate-based compound (B).

In order to prepare the hologram recording material composition, for example, the allyl-based prepolymer (A), the (meth)acrylate-based compound (B) and the photo-polymerization initiator (C), as well as the optional components described above such as the solvent-soluble thermoplastic resin (D), the additives and the solvent are placed in a vessel resistant to an organic solvent, such as a glass beaker, and the whole content is stirred. In this case, in order to accelerate dissolution of solid components, the composition can be heated to a range in which denaturation of the composition does not occur, such as to a temperature of about from 40 to 90°C.

In order to produce a hologram recording medium by using the hologram recording material composition of the invention, the recording material composition is coated on one surface of a substrate to obtain a recording medium having a two-layer structure consisting of the coated film thus formed, i.e., a recording layer, and the substrate. A three-layer structure is obtained, if necessary, by placing a protective material in the form of a film, a sheet or a plate to cover the recording layer formed on the substrate. In the process for preparing the composition, a solvent is preferably used. In this case, the allyl-based prepolymer (A), the (meth)acrylate-based compound (B) and the photo-polymerization initiator (C) are dissolved or suspended in a solvent, and a solution or a suspension thus obtained is coated on a substrate. Thereafter, the solvent is vaporized to obtain a recording layer. In the case where a protective material is placed to cover the recording layer, it is preferred that the solvent is removed by air drying or vaporization under reduced pressure before placing the protective material. The substrate is made of an optically transparent material, such as a glass plate and a plastic plate, such as a polyethylene terephthalate (hereinafter abbreviated as PET) plate, a polycarbonate plate and a polymethyl methacrylate plate, The thickness of the substrate is preferably from 0.5 to 10 mm. The protective material is also made of an optically transparent material as similar to the substrate. The substrate does not necessarily have to be flat, but can be bent or curved and can have an uneven structure on the surface thereof. The thickness of the protective material is preferably from 0.01 to 10 mm. Examples of the coating method include a gravure coating method, a roll coating method and a bar coating method. The coating is preferably conducted in such a manner that the thickness of the recording layer after removing the solvent is from 1 to 100 µm.

In order to record a hologram onto the hologram recording medium, a recording method generally employed can be used. That is, laser light is split into two, and one split light is irradiated onto an object to be recorded. A recording medium is arranged at a specified position. At the position an interference fringe can be caught which is formed with object light reflected from the object and another split light, i.e., reference light. Irradiating laser light for about from several seconds to several minutes under such an arrangement, an interference fringe to be a hologram is recorded on the recording medium. The light amount of the laser light used is, in terms of a product of the light intensity and the irradiation time, preferably about from 10 to 10,000 mJ/cm². When the light amount is less than the range, recording is difficult to be conduct, whereas when it exceeds the range, the diffraction efficiency of the hologram tends to be lowered, and therefore the both cases are not preferred.

After forming the hologram, a post-processing, such as development and fixing, is not always necessary, but in order to stabilize the resulting image, the medium can be subjected to a irradiation treatment with light on the whole surface thereof or a heat treatment to post-polymerize the remaining unreacted monomer.

A hologram can be copied on a recording medium obtained by using the recording medium composition of the invention. For example, a recorded hologram plate, as an original image, is superposed closely on the surface of the protective material of the recording material having the three-layer structure described above, and the hologram plate having the original image is irradiated with light using a high pressure mercury lamp. Interference occurs at the recording layer of the non-recorded recording medium between reference light suffering no diffraction and diffracted light of the original image (i.e., object light), and the hologram is copied onto the recording medium to obtain a hologram of high fidelity to the original image. When a hologram of good quality can be obtained by the copying process described above, such becomes evidence that a hologram can be produced by interference of laser light.

After producing a hologram in the recording medium obtained by using the recording material composition of the invention, the prepolymer (A) remains in the recording medium. Therefore, it is considered that the remaining allyl-based prepolymer is functionally utilized. For example, when the substrate is formed with an unsaturated polyester resin, and the remaining allyl group of the prepolymer (A) is chemically bonded to an unsaturated group of the resin of the substrate, the recording material composition of the invention can be firmly fixed on the substrate. By utilizing the function of the remaining allyl group of the allyl-based prepolymer (A), various properties can be given to the material characteristics of the hologram to obtain a hologram that has physical properties applicable to various kinds of usage.

In the recording material composition of the invention, the allyl-based prepolymer (A) and the (meth)acrylate-based compound (B) are completely dissolved each other before exposure to light, and on irradiation with laser light, the (meth)acrylate-based compound (B) is polymerized through photo-polymerization, and finally becomes a hologram recording layer.

Accordingly, when the two-layer structure, which comprises a substrate having the recording material composition coated thereon, or the three-layer structure, which comprises the two-layer structure having a protective layer formed on the recording layer, is exposed to an interference pattern, photo-polymerization of the (meth)acrylate-based compound (B) having a high photo-polymerization reactivity begins to occur at a portion of a large light amount. and volume shrinkage occurs at that portion. An unreacted compound flows from a portion of a small light amount into a concave portion formed by the volume shrinkage, and the allyl-based prepolymer (A) diffuses into the portion of a small light amount by phase separation between the allyl-based prepolymer (A) and the (meth)acrylate-based compound (B), so that the (meth)acrylate-based compound (B) is diffused to migrate into the portion of a large light amount to further proceed the photo-polymerization. In the portion of a small light amount, on the other hand, the photo-polymerization proceeds with a small delay from the portion of a large light amount. As a result, a polymer of the (meth)acrylate-based compound (B) having a small refractive index is accumulated in the portion of a large light amount, and a polymer containing the allyl-based prepolymer (A) having a large refractive index is accumulated in the portion of a small light amount. In the case where fluorene (meth)acrylate is used as the (meth)acrylate-based compound (B), a fluorene (meth)acrylate polymer having a large refractive index is accumulated at the portion of a large light amount, and a polymer containing the allyl-based prepolymer (A) having a small refractive index is accumulated in the portion of a small light amount.

Accordingly, a compositional distribution corresponding to the light amount, i.e., an interference pattern based on the difference in refractive index between a portion having a large amount of the allyl-based prepolymer (A) and a portion having a large amount of the (meth)acrylate-based compound (B), is formed as a hologram.

### DESCRIPTION OF THE PREFERRED EMBODIMENTS

The invention will be specifically described with reference to several examples, but the invention is not construed as being limited thereto.

### EXAMPLE 1

(1) 8 g of diallylorthophthalate prepolymer ("Daiso DAP Type A" produced by Daiso Co., Ltd.), 2 g of ethylene glycol dimethacrylate ("NK Ester 1G" produced by Shin-Nakamura Chemical Co.. Ltd.), 0.3 g of benzil as a polymerization initiator, 0.1 g of Michler's ketone as a photo-sensitizing dye, and 22g of acetone were mixed at an ordinary temperature to prepare a recording material composition comprising these components.
(2) The composition was coated on one surface of a glass plate substrate having a dimension of 76 x 26 x 1.2 mm to a thickness of 10 µm. Acetone was removed from the coated layer under reduced pressure, to produce a recording material having a two-layer structure comprising the substrate and the recording layer.
   In the recording layer of the recording material, no phase separation or deposition of a polymer and a monomer was observed. Since the recording layer was substantially in a solid state, when touched with hand, it was not attached to hand, and did not drip. Therefore, the recording layer was excellent in handling, suffered no shift from the substrate, and was easy to transport. Further, the thickness of the recording layer was kept constant.
(3) A protective material comprising a PET film having a size of 76 x 26 mm and a thickness of 10 µm was placed to cover the recording layer, to produce a three-layer photosensitive plate for recording a hologram.
(4) Another hologram plate (uffraction efficiency; ca. 60%, resolution; ca, 2,000 lines per mm), in which 70 lines per mm had been recorded, as an original image was superposed closely on the surface of the protective material of the non-recorded photosensitive plate, and the hologram plate as the original image was irradiated with light emitted from a high pressure mercury lamp of 100 W (having peak wavelengths at 365, 410 and 430 nm) from the upper side thereof with a distance of about 10 cm for 1 to 3 minutes, so as to copy the hologram to the non-recorded photosensitive plate. When the illuminance was measured with an illuminance meter capable of measuring a wavelength of from 330 to 490 nm, the energy was 3.0 mW/cm² or less at a distance of 10 cm from the light source. Therefore, even when the recording was continued for 10 minutes, the energy became only about 1,800 mJ/cm².

A copy thus obtained suffered no coloring, and had a high brightness of a diffraction efficiency of about 30% without conducting development and fixing.

The copied hologram maintained a stable image for a long period of 3 months or more, after peeling the protective material. The record was formed only with the refractive index modulation, but not uneveness on the recording layer, and a transparent hologram having substantially no absorption in the visible region was obtained.

Since a hologram of good quality was obtained through the copying process described above, it was evidenced that a hologram could be produced by laser interference.

### EXAMPLES 2 TO 8

(1) The same procedures as in item (1) of Example 1 were repeated to produce recording material compositions, except that the ratio of the diallylorthophthalate prepolymer and ethylene glycol dimethacrylate was changed as follows:
   prepolymer/monomer = 9/1 (g/g) (Example 2)
   prepolymer/monomer = 7/3 (g/g) (Example 3)
   prepolymer/monomer = 6/4 (g/g) (Example 4)
   prepolymer/monomer = 5/5 (g/g) (Example 5)
   prepolymer/monomer = 4/6 (g/g) (Example 6)
   prepolymer/monomer = 3/7 (g/g) (Example 7)
   prepolymer/monomer = 2/8 (g/g) (Example 8)
(2) to (4) Photosensitive plates for recording a hologram were produced and holograms were copied by conducting the same manner as in items (2) to (4) of Example 1.

Copies thus obtained suffered no coloring, and had a high brightness of a diffraction efficiency of about 30% without conducting development and fixing.

The copied holograms maintained a stable image for a long period of 3 months or more, after peeling the protective material. The records were formed only with the refractive index modulation, but not unevenness on the recording layer, and transparent holograms having substantially no absorption in the visible region were obtained.

### EXAMPLE 9

(1) 3.5 g of diallylorthophthalate prepolymer ("Daiso DAP Type K" produced by Daiso Co., Ltd.), 1.5 g of ethylene glycol dimethacrylate ("NK Ester 1G" produced by Shin-Nakamura Chemical Co., Ltd.), 0.15 g of benzil, 0.05 g of Michler's ketone, and 11g of acetone were mixed at an ordinary temperature to prepare a recording material composition comprising these components.
(2) to (4) A photosensitive plate for recording a hologram was produced and a hologram was copied by conducting the same manner as in items (2) to (4) of Example 1.

A copy thus obtained suffered no coloring, and had a high brightness of a diffraction efficiency of about 30% without conducting development and fixing.

The copied hologram maintained a stable image for a long period of 3 months or more, after peeling the protective material. The record was formed only with the refractive index modulation, but not unevenness on the recording layer, and a transparent hologram having substantially no absorption in the visible region was obtained.

### EXAMPLE 10

(1) The same procedures as in item (1) of Example 9 were repeated to produce a recording material composition, except that the diallylorthophthalate prepolymer was changed to diallylisophthalate prepolymer ("Daiso ISO-DAP" produced by Daiso Co., Ltd.).
(2) to (4) A photosensitive plate for recording a hologram was produced and a hologram was copied by conducting the same manner as in items (2) to (4) of Example 1.

A copy thus obtained suffered no coloring, and had a high brightness of a diffraction efficiency of about 30% without conducting development and fixing.

The copied hologram maintained a stable image for a long period of 3 months or more, after peeling the protective material. The record was formed only with the refractive index modulation, but not unevenness on the recording layer, and a transparent hologram having substantially no absorption in the visible region was obtained.

### EXAMPLES 11 TO 23

(1) The same procedures as in item (1) of Example 9 were repeated to produce recording material compositions, except that the diallylorthophthalate prepolymer ("Daiso DAP Type K" produced by Daiso Co., Ltd.) was changed to diallylorthophthalate prepolymer ("Daiso DAP Type A" produced by Daiso Co., Ltd.), and the ethylene glycol dimethacrylate was changed to the following.
   Triethylene glycol dimethacrylate ("NK Ester 3G" produced by Shin-Nakamura Chemical Co., Ltd.) (Example 11)
   1,3-Butanediol dimethacrylate ("NK Ester BG" produced by Shin-Nakamura Chemical Co., Ltd.) (Example 12)
   1,6-Hexanediol dimethacrylate ("NK Ester HD" produced by Shin-Nakamura Chemical Co., Ltd.) (Example 13)
   Neopentyl glycol dimethacrylate ("NK Ester NPG" produced by Shin-Nakamura Chemical Co.. Ltd.) (Example 14)
   Tetraethylene glycol diacrylate ("NK Ester A-200" produced by Shin-Nakamura Chemical Co., Ltd.) (Example 15)
   Nonaethylene glycol diacrylate ("NK Ester A-400" produced by Shin-Nakamura Chemical Co., Ltd.) (Example 16)
   1,6-Hexanediol diacrylate ("NK Ester A-HD" produced by Shin-Nakamura Chemical Co., Ltd.) (Example 17)
   Neopentyl glycol diacrylate ("NK Ester A-NPG" produced by Shin-Nakamura Chemical Co., Ltd.) (Example 18)
   Trimethylolpropane trimethacrylate ("NK Ester TMPT" produced by Shin-Nakamura Chemical Co., Ltd.) (Example 19)
   Trimethylolpropane triacrylate ("NK Ester A-TMPT" produced by Shin-Nakamura Chemical Co., Ltd.) (Example 20)
   Tetramethylolmethane tetraacrylate ("NK Ester A-TMMT" produced by Shin-Nakamura Chemical Co., Ltd.) (Example 21)
   Dipentaerythritol hexaacrylate ("NK Ester ADP-6" produced by Shin-Nakamura Chemical Co., Ltd.) (Example 22)
   9,9-Bis(4-(2-acryloyloxyethoxy)phenyl) fluorene ("BPEFA" produced by Osaka Gas Co., Ltd.) (Example 23)
(2) to (4) Photosensitive plates for recording a hologram were produced and holograms were copied by conducting the same manner as in items (2) to (4) of Example 1.

Copies thus obtained suffered no coloring, and had a high brightness of a diffraction efficiency of about 30% without conducting development and fixing.

The copied holograms maintained a stable image for a long period of 3 months or more, after peeling the protective material. The records were formed only with the refractive index modulation, but not unevenness on the recording layer, and transparent holograms having substantially no absorption in the visible region were obtained.

### EXAMPLE 24

(1) 6 g of diallylorthophthalate prepolymer ("Daiso DAP Type A" produced by Daiso Co., Ltd.), 4 g of ethylene glycol dimethacrylate ("NK Ester 1G" produced by Shin-Nakamura Chemical Co., Ltd.), 0.5 g of benzil, 0.17 g of Michler's ketone, and 22g of acetone were mixed at an ordinary temperature to prepare a recording material composition comprising these components.
(2) The composition was coated on one surface of a glass plate substrate having a dimension of 50 x 50 x 1.5 mm to a thickness of 10 µm. Acetone was removed from the coated layer under reduced pressure, to produce a recording material having a two-layer structure comprising the substrate and the recording layer.
(3) A protective material comprising a glass plate having the same size as the substrate was placed to cover the recording layer, to produce a three-layer photosensitive plate of a sandwich form for recording a hologram.
(4) An object to be recorded was irradiated with He-Cd laser light, and interference was formed between reference light reflected from a reflector and object light reflected from the object. The three-layer photosensitive plate for recording a hologram was placed at a position, at which a fringe pattern formed by the interference could be caught. The photosensitive plate was exposed to the He-Cd laser light (9 mW/cm²) for a prescribed period of time under the conditions, and an interference fringe to be a hologram could be recorded on the photosensitive plate only by this operation with an exposure time of either 15 seconds, 30 seconds. 45 seconds, 1 minute, 2 minutes, 5 minutes or 10 minutes.

No operation of development or fixing was necessary. Because the recording layer was sandwiched by the two glass places, the thickness of the recording layer was uniform after exposure. There was no unevenness between a portion that had been Irradiated with light of a high intensity and a portion that had been irradiated with light of a low intensity, and the record was formed with a refractive index modulation. A transparent hologram having a high brightness (resolution: 940 lines per mm) and substantially no absorption in the visible region was thus obtained. A stable image was maintained after removing the protective material.

### EXAMPLE 25

(1) 5 g of diallylorthophthalate prepolymer ("Daiso DAP Type A" produced by Daiso Co., Ltd.), 5 g of ethylene glycol dimethacrylate ("NK Ester 1G" produced by Shin-Nakamura Chemical Co., LtD.), 0.5 g of benzil, 0.17 g of Michler's ketone, and 22g of acetone were mixed at an ordinary temperature to prepare a recording material composition comprising these components.
(2) The composition was coated on one surface of a glass plate substrate having a dimension of 50 x 60 x 1.5 mm to a thickness of 10 µm. Acetone was removed from the coated layer under reduced pressure, to produce a recording material having a two-layer structure comprising the substrate and the recording layer.
(3) A protective material comprising a PET film having a size of 50 x 60 mm and a thickness of 10 µm was placed to cover the recording layer, to produce a three-layer photosensitive plate for recording a hologram.
(4) An object to be recorded was irradiated with He-Cd laser light, and interference was formed between reference light reflected from a reflector and object light reflected from the object. The three-layer photosensitive plate for recording a hologram was placed at a position, at which a fringe pattern formed by the interference could be caught. The photosensitive plate was exposed to the He-Cd laser light (9 mW/cm²) for a prescribed period of time under the conditions, and an interference fringe to be a hologram could be recorded on the photosensitive plate only by this operation with an exposure time of either 15 seconds, 30 seconds, 45 seconds, 1 minute, 2 minutes. 5 minutes or 10 minutes.

No operation of development or fixing was necessary. Because the recording layer was sandwiched by the glass plate and the protective material comprising the PET film, the thickness of the recording layer was uniform after exposure. There was no unevenness between a portion that had been irradiated with light of a high intensity and a portion that had been irradiated with light of a low intensity, and the record was formed with a refractive index modulation. A transparent hologram having a high brightness (resolution: 940 lines per mm) and substantially no absorption in the visible region was thus obtained. A stable image was maintained after removing the protective material.

### EXAMPLE 26

(1) A recording material composition was produced by repeating the same procedures as in item (1) of Example 1.
(2) The composition was coated on one surface of a glass plate substrate having a dimension of 30 x 60 x 1.5 mm to a thickness of 10 µm. Acetone was removed from the coated layer under reduced pressure, to produce a recording material having a two-layer structure comprising the substrate and the recording layer.
(3) A protective material comprising a glass plate having the same size as the substrate was placed to cover the recording layer, to produce a three-layer photosensitive plate of a sandwich form for recording a hologram.
(4) An object to be recorded was irradiated with He-Cd laser light, and interference was formed between reference light reflected from a reflector and object light reflected from the object. The three-layer photosensitive plate for recording a hologram was placed at a position, at which a fringe pattern formed by the interference could be caught. The photosensitive plate was exposed to the He-Cd laser light (10 mW/cm²) for a prescribed period of time under the conditions, and an interference fringe to be a hologram could be recorded on the photosensitive plate only by this operation.

No operation of development or fixing was necessary. Because the recording layer was sandwiched by the two glass plates, the thickness of the recording layer was uniform after exposure. There was no unevenness between a portion that had been irradiated with light of a high intensity and a portion that had been irradiated with light of a low intensity, and the record was formed with a refractive index modulation. A transparent hologram having a high brightness (diffraction efficiency: 60%, resolution; 2,000 or more lines per mm) and substantially no absorption in the visible region was thus obtained. A stable image was maintained after removing the protective material.

The recording material compositions obtained in Examples 1 to 23 and capability of copying conducted by using them are shown in Tables 1 and 2.

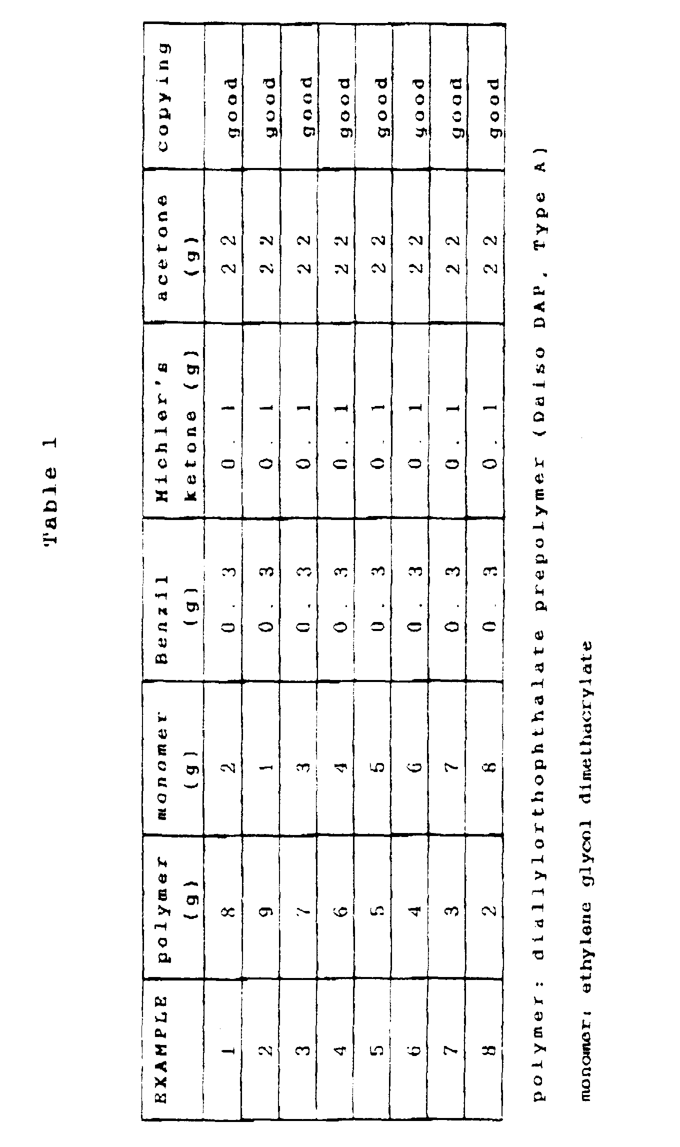

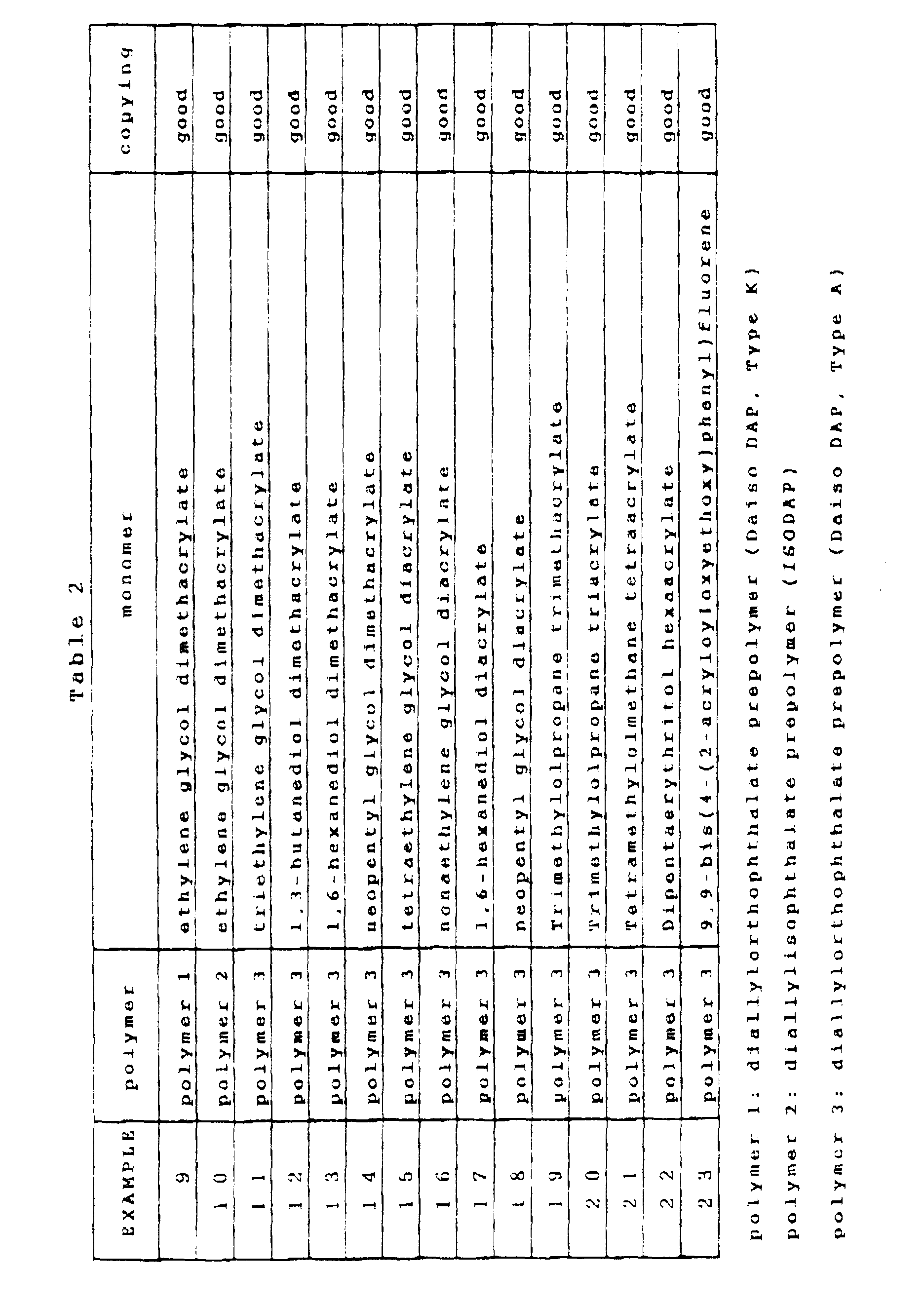

### EXAMPLES 27 TO 36

(1) 2 g of diallylorthophthalate prepolymer ("Daiso DAP Type A" produced by Daiso Co., Ltd.), 3 g of a (meth)acrylate monomer shown in Table 3, 0.25 g of benzil, 0.085 g of Michler's ketone, and 3.5g of acetone were mixed at an ordinary temperature to prepare recording material compositions comprising these components.
(2) The compositions were coated on one surface of a glass plate substrate having a dimension of 60 x 60 x 1.3 mm in an appropriate amount, and acetone was removed from the coated layer under reduced pressure, to produce recording materials having a two-layer structure comprising the substrate and the recording layer.
(3) A PET film in a strip form having a size of 1 x 60 mm and a thickness of 20 µm was placed on the recording layer, and a protective material comprising a glass plate having the same size as the substrate was placed thereon, to produce three-layer photosensitive plates having a sandwich form for recording a hologram.
(4) Interference was formed between object light and reference light by using a He-Cd laser. The three-layer photosensitive plate for recording a hologram was placed at a position, at which a fringe pattern formed by the interference could be caught. The photosensitive plate was exposed to He-Cd laser light (2.5 mW/cm²) for a prescribed period of time under the conditions, and an interference fringe to be a hologram could be recorded on the photosensitive plate.

The recording material compositions obtained in Examples 27 to 36 and results of measurement of diffraction efficiency conducted by using them are shown in Table 3.

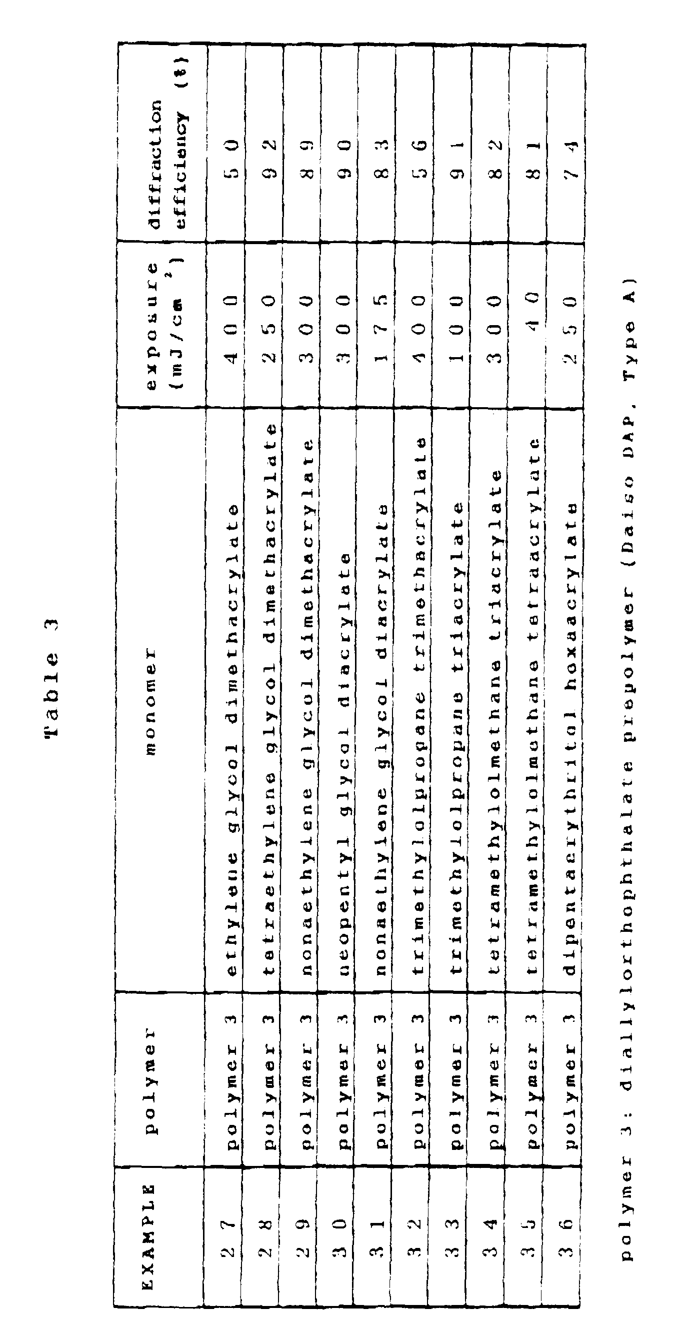

### EXAMPLE 37

(1) 2 g of diallylorthophthalate prepolymer ("Daiso DAP Type A" produced by Daiso Co., Ltd.), 3 g of neopentyl glycol diacrylace ("NK Ester A-NPG" produced by Shin-Nakamura Chemical Co., Ltd.), 1.75 g of
   3,3'4,4'-tetra(tert-butylperoxycarbonyl)benzophezone ("BTTB-25" produced by NOF Corporation) as a polymerization initiator, 0.005 g of 3,3'-carbonylbis(7-(diethylamino)coumarin) ("BC" produced by Midori Kagaku Co., Ltd.) as a photosensitizing dye, and 4 g of acetone were mixed at an ordinary temperature to prepare a recording material composition comprising these components.
(2) The composition was coated on one surface of a glass plate substrate having a dimension of 60 x 60 x 1.3 mm in an appropriate amount, and acetone was removed from the coated layer under reduced pressure, to produce a recording material having a two-layer structure comprising the substrate and the recording layer.
(3) A PET film in a strip form having a size of 1 X 60 mm and a thickness of 20 µm was placed on the recording layer, and a protective material comprising a glass plate having the same size as the substrate was placed thereon, to produce a three-layer photosensitive plate having a sandwich form for recording a hologram.
(4) Interference was formed between object light and reference light by using an Ar laser (wavelength: 488 nm). The three-layer photosensitive plate for recording a hologram was placed at a position, at which a fringe pattern formed by the interference could be caught. The photosensitive plate was exposed to Ar laser light (20 mW/cm²) for a prescribed period of time under the conditions, and an interference fringe to be a hologram could be recorded on the photosensitive plate.

The resulting hologram exhibited a diffraction efficiency of 89% at an exposed amount of 100 mJ/cm².

### EXAMPLE 38

(1) 2.3 g of diallylorthophthalate prepolymer ("Daiso DAP Type A" produced by Daiso Co.. Ltd.), 1.8 g of
   9,9-bis(4-(2-acryloyloxyethoxy)phenyl) fluorene ("BPEFA" produced by Osaka Gas Co., Ltd.), 0.9 g of vinyl bisphenylcarboxylate (produced by Nippon Steel Chemical Co., Ltd.), 1.75 g of
   3,3'4,4'-tetra(tert-butylperoxycarbonyl)benzophenone ("BTTB-25" produced by NOF Corporation), 0.005 g of 3,3'-carbonylbis(7-(diethylamino)coumarin) (BC produced by Midori Kagaku Co., Ltd.), and 4 g of tetrahydrofuran were mixed at an ordinary temperature to prepare a recording material composition comprising these components.
(2) The composition was coated on one surface of a glass plate substrate having a dimension of 60 x 60 x 1.3 mm in an appropriate amount, and tetrahydrofuran was removed from the coated layer under reduced pressure, to produce a recording material having a two-layer structure comprising the substrate and the recording layer.
(3) A PET film in a strip form having a size of 1 x 60 mm and a thickness of 20 µm was placed on the recording layer, and a protective material comprising a glass plate having the same size as the substrate was placed thereon, to produce a three-layer photosensitive plate having a sandwich form for recording a hologram.
(4) Interference was formed between object light and reference light by using an Ar laser (wavelength; 488 nm). The three-layer photosensitive plate for recording a hologram was placed at a position, at which a fringe pattern formed by the interference could be caught. The photosensitive plate was exposed to Ar laser light (2 mW/cm²) for a prescribed period of time under the conditions, and an interference fringe to be a hologram could be recorded on the photosensitive plate.

The resulting hologram exhibited a diffraction efficiency of 47% at an exposed amount of 40 mJ/cm².

### EXAMPLE 39

(1) 2.3 g of triallylisocyanurate prepolymer ("TAIC Prepolymer" produced by Nippon Kasei Chemical Co., Ltd.), 2.7 g of neopentyl glycol diacrylate ("NK Ester A-NPG" produced by Shin-Nakamura Chemical Co., Ltd.), 1.75 g of 3,3'4,4'-tetra(tert-butylperoxycarbonyl)benzophenone ("BTTB-25" produced by NCF corporation), 0.02 g of 3,3'-carbonylbis(7-(diethylamino)coumarin) ("BC" produced by Midori Kagaku Co., Ltd.), and 4 g of acetone were mixed at an ordinary temperature to prepare a recording material composition comprising these components.
(2) to (4) A photosensitive plate for recording a hologram was produced and a hologram was obtained by conducting the same procedures as in items (2) to (4) of Example 38.

The resulting hologram could be recorded with an exposure light amount of 50, 100 and 200 mJ/cm², and exhibited a diffraction efficiency of about 30%.

### EXAMPLE 40

(1) 5.5 g of diallylorthophthalate prepolymer ("Daiso DAP Type A" produced by Daiso Cc., Ltd.) was dissolved in 27.5 ml of acetone. 0.41 g of a 0.1N HCl aqueous solution was dissolved in 4.5 g of phenyltrimethoxysilane that had been separately prepared, and the resulting solution was mixed with the acetone solution obtained above, followed by stirring at 20°C for 1 hour. The resulting solution was heated in an oven with a temperature increasing rate of 10°C per hour from 20 to 80°C, and was allowed to stand at 80°C for 3 days, to remove the solvent, methanol as a by-product and water. As a result. a transparent uniform complex of a diallylphthalate and an inorganic substance was obtained as a reaction product.
(2) 2.5 g of the reaction product, 2.5 g of neopentyl glycol diacrylate ("NK Ester A-NPG" produced by Shin-Nakamura Chemical Co., Ltd.), 1.75 g of 3,3'4,4'-tetra(tert-butylperoxycarbonyl)benzophenone ("BTTB-25" produced by NOF Corporation), 0.005 g of 3,3'-carbonylbis(7-(diethylamino)coumarin) ("3C" produced by Midori Kagaku Co., Ltd.), and 4 g of acetone were mixed at an ordinary temperature to prepare a recording material composition comprising these components.
(3) to (5) A photosensitive plate for recording a hologram was produced and a hologram was obtained by conducting the same procedures as in items (2) to (4) of Example 38.

The resulting hologram could be recorded with an exposure light amount of 50, 100 and 150 mJ/cm², and exhibited a diffraction efficiency of about 30%.

### EXAMPLE 41

(1) 3 g of diallylorthophthalate prepolymer ("Daiso DAP Type A" produced by Daiso Co., Ltd.), 1 g of thiophenol ("TP" produced by Sumitomo Seika Chemicals Co., Ltd.), and 0.02 g of azobisisobutyronitrile as a catalyst were dissolved in 30 ml of acetone. The resulting solution was refluxed at 70°C for 2 hours, and put in 200 g of methanol, in which 0.1 g of hydroquinone had been dissolved, to obtain an adduct of a diallylorthophthalate prepolymer and thiol, as a reaction product.
(2) 2.5 g of the reaction product, 2.5 g of neopentyl glycol diacrylate ("NK Ester A-NPG" produced by Shin-Nakamura Chemical Co., Ltd.), 1,75 g of 3,3'4,4'-tetra(tert-butylperoxycarbonyl)benzophenone ("BTTB-25" produced by NOF Corporation), 0,005 g of 3,3'-carbonylbis(7-(diethylamino)coumarin) ("BC" produced by Midori Kagaku Co., Ltd.), and 4 g of acetone were mixed at an ordinary temperature to prepare a recording material composition comprising these components.
(3) to (5) A photosensitive plate for recording a hologram was produced and a hologram was obtained by conducting the same procedures as in items (2) to (4) of Example 38.

The resulting hologram could be recorded with an exposure light amount of 50, 100 and 150 mJ/cm², and exhibited a diffraction efficiency of about 30%.

### EXAMPLE 42

(1) 10 g of diallylorthophthalate prepolymer ("Daiso DAP Type A" produced by Daiso Co., Ltd.) was dissolved in 300 ml of carbon tetrachloride. 30 ml of bromine was added dropwise to the solution over 1 hour with stirring at 5°C or less. The resulting solution was put in 1,000 g of methanol, in which 0.1 g of hydroquinone had been dissolved, to obtain an adduct of a diallylorthophthalate prepolymer and bromine deposited as a reaction product.
(2) 2.5 g of the reaction product, 2.5 g of neopentyl glycol diacrylate ("NK Ester A-NPG" produced by Shin-Nakamura Chemical Co., Ltd.), 1.75 g of 3,3'4,4'-tetra(tert-butylperoxycarbonyl)benzophenone ("BTTB-25" produced by NOF Corporation), 0.005 g of 3,3'-carbonylbis(7-(diethylamino)coumarin) ("BC" produced by Midori Kagaku Co., Ltd.), and 4 g of acetone were mixed at an ordinary temperature to prepare a recording material composition comprising these components.
(3) to (5) A hologram was obtained by conducting the same procedures as in items (2) to (4) of Example 38.

The resulting hologram could be recorded with an exposure light amount of 50, 100 and 150 mJ/cm², and exhibited a diffraction efficiency of about 30%.

In Examples 27 to 42, no operation of development or fixing was necessary. Because the recording layer was sandwiched by the two glass places, the thickness of the recording layer was uniform after exposure. There was no unevenness between a portion that had been irradiated with light of a high intensity and a portion that had been irradiated with light of a low intensity, and the record was formed with a refractive index modulation. A transparent hologram having a high brightness and substantially no absorption in the visible region was thus obtained. A stable image was maintained after removing the protective material.

### Example 43

8.5 g of diallylorthophthalate prepolymer ("Daiso DAP Type A" produced by Daiso Co.. Ltd.), 10 g of ethylene glycol dimethacrylate ("NK Ester 1G" produced by Shin-Nakamura Chemical Co., Ltd.), 1.5 g of polyarylate ("U-100" produced by Unitika Ltd,) as a solvent-soluble thermoplastic resin, 0.5 g of benzil as a polymerization initiator, 0.2 g of Michler's ketone as a photo-sensitizing dye and 20 g of dichloromethane were mixed at an ordinary temperature to prepare a recording material composition comprising these components.

(2) to (4) A photosensitive plate for recording a hologram was produced and a hologram was copied by conducting the same manner as in items (2) to (4) of Example 1.

A copy thus obtained suffered no coloring, and had a high brightness of diffraction efficiency of about 35% conducting development and fixing.

### Example 44

The same procedures as in Example 43 were repeated, except that 1.5 g of polysulfone ("Udel P-1700" produced by Amoco Polymers Inc.) as solvent-soluble thermoplastic resin was used, to produce recording material composition and a photosensitive plate for recording hologram on which a hologram was copied.

A copy thus obtained suffered no coloring, and had a high brightness of diffraction efficiency of about 35% conducting development and fixing.

Because the hologram recording material composition of the invention is substantially in a solid state, a heat treatment for solidifying a flowable composition, as a conventional product, is not necessary. Therefore, the comosition of the invention can simplify the film formation operation on producing a hologram recording medium, and thus exhibits good workability.

Because the recording layer obtained from the hologram recording material composition of the invention is substantially in a solid state, it is excellent in handling as when touched with hand, it does not contaminate hand. Additionally, in the recording material having the recording layer, the recording layer suffers no drip or shift from the substrate when it is slanted, and it is thus easy to transport.

Furthermore, the recording material after recording a hologram has a high transparency and is excellent in stability because the allyl-based prepolymer (A) and the (meth)acrylate-based compound (B) are present in the form of a polymer having a sufficient high molecular weight, and it is free of a problem in that a record becomes unclear due to re-diffusion of them. Therefore, an operation of development or fixing for stabilizing the recorded image is not necessary, and thus a hologram can be recorded by a real-time operation.

According to the invention, a hologram recording material composition can be provided that can eliminate complication in film forming operation, which is the problems associated with the conventional product, while exhibiting good performance demanded for a hologram, such as a transparency, a diffraction efficiency and a resolution, as similar to the conventional product.

## Claims

1. A hologram recording material composition comprising (A) an allyl-based prepolymer having at least one allyl group in a molecule thereof, (B) a (meth)acrylate-based compound having at least one polymerizable unsaturated group in a molecule thereof, and (C) a photo-polymerization initiator, wherein a difference between a refractive index of said allyl-based prepolymer (A) and a refractive index of a polymer of said (meth)acrylate compound (B) is 0.005 or more.

2. A hologram recording material composition as claimed in claim 1, wherein said composition further comprises (D) a solvent-soluble thermoplastic resin in a weight ratio to said allyl-based prepolymer (A), (A)/(D) of from 80/20 to 100/0.

3. A hologram recording material composition as claimed in claim 2, wherein said allyl-based prepolymer (A) is a homopolymer of an allyl-based monomer or a copolymer of said allyl-based monomer and another copolymerizable monomer.

4. A hologram recording material composition as claimed in claim 3, wherein said allyl-basad monomer is a diallylphthalate-based monomer.

5. A hologram recording material composition as claimed in claim 2, wherein said allyl-based prepolymer (A) is an organic-inorganic complex transparent uniform material obtained by subjecting a metallic alkoxide having a metallic atom, a group having an aromatic ring, and a hydrolyzable group to dehydration condensation by a sol-gel method in the presence of a diallyl phthalate-based monomer and/or a diallyl phthalate-based polymer.

6. A hologram recording material composition as claimed in claim 2, wherein said allyl-based prepolymer (A) has a thioether group and/or a halogen atom connected to a main chain thereof.

7. A hologram recording material composition as claimed in claim 2, wherein said allyl-based prepolymer (A) is a diallylphthalate-based prepolymer.

8. A hologram recording material composition as claimed in claim 7, wherein said diallylphthalate-based prepolymer is a prepolymer selected from the group consisting of a diallylorthophthalate prepolymer, a diallylisophthalate prepolymer and a diallylterephthalate prepolymer, or a combination of two or more thereof.

9. A hologram recording material composition as claimed in one of claims 1 to 8, wherein said allyl-based prepolymer has a molecular weight of from 10,000 to 100,000.

10. A hologram recording material composition as claimed in claim 9, wherein said (meth)acrylace-based compound (B) contains from 1 to 6 of polymerizable unsaturated group, and has a molecular weight of 2,000 or less.

11. A hologram recording material composition as claimed in claim 10, wherein said (methacrylate-based compound (B) is a di(meth)acrylate.

12. A hologram recording material composition as claimed in claim 11 wherein a weight ratio of said allyl-based prepolymer (A) to said acrylic acid alkyl ester (B), (A)/(B) is from 5/95 to 95/5.

13. A hologram recording medium comprising a substrate having formed thereon a recording layer comprising a hologram recording material composition claimed in claim 1.
